# EUROPEAN PATENT APPLICATION

(11) **EP 0 554 079 A2**
(43) Date of publication of application: **04.08.1993**
(21) Application number: 93300607.4
(22) Date of filing: 28.01.1993
(51) Int. Cl.: C23F 1/00

(54) **A reactive gas for plasma assisted chemical etching and method for stable plasma etching of substrates over edges**

(30) Priority: 31.01.1992 US 829995
(71) Applicant: Hughes Aircraft Company, Los Angeles, California 90080-0028 (US)
(72) Inventor: Bollinger, L. D., Ridgefield, CT 06877 (US); Steinberg, George N., Westport, CT 06880 (US)
(74) Representative: Colgan, Stephen James

(57) **Abstract**

A small percentage of an electronegative gas is included in a gas mixture which is fed into a plasma region of a plasma assisted chemical etching apparatus so as to suppress arc-like discharges at surface discontinuities of a substrate which is receiving etching treatment to shape the surface thereof.

## Description

### BACKGROUND OF THE INVENTION

### Field of the Invention

The present invention relates to a reactive gas composition and method for controlling material removal by plasma etching over an entire surface of a substrate. More particularly the present invention is directed to a reactive gas composition and method to obtain very stable, controlled plasma etching, including use of high power density plasmas, over the edges and other small discontinuities of a substrate. Thus, the present invention provides a means for performing controlled optical figuring, modifications of the thickness profile of a solid layer, and removal of damaged layers from a surface.

### Description of the Prior Art

Plasma etching applications, particularly optical figuring and film thinning, may require plasma etching over surface discontinuities of a substrate, such as the edges or small gaps on the surface. Such discontinuities can cause an intense arc-like discharge which may result in an associated localized, uncontrolled and sometimes very high volume of material removal from the surface of the substrate. Thus, when a plasma is used to perform optical figuring, to modify the thickness profile of a solid layer or to remove damage layers from a surface, it is necessary to controllably and predictably etch across the edge of the substrate so as to obtain the desired removal depth over the entire substrate surface.

Heretofore, prior art methods have surrounded the substrate edges very tightly with material which has approximately the same electrical, physical and chemical properties as the substrate so as to minimize the discontinuity that the plasma experiences at the edge of the substrate. Other prior art methods have enlarged the substrate itself so that it is oversized relative to the useful substrate size for a given substrate application. This use of an enlarged substrate ensures that no edge of the substrate is exposed to the plasma. However, both of these prior art solutions add expense and waste to the plasma etching process and, further, depending on the substrate, they may be impractical.

Another solution that has been employed to overcome substrate edge effects is to use a plasma parameter for which stable plasma operation is obtained, such as a very low power density. However, such low power densities result in low material removal rates and may be very limiting to the useful plasma parameter range (e.g. discharge power, gas pressure).

The present invention is directed to improvements over these prior art techniques, particularly over control of the plasma etching at the edge of a substrate so as to provide a material removal tool with predictable, controllable and adequate removal rates.

### SUMMARY OF THE INVENTION

The present invention is directed to a reactive gas composition and method for controllably removing material from a substrate surface by a plasma assisted chemical etching process especially at the edges of the surface. The present invention adds an electronegative gas to a process gas mixture fed to the plasma region of the plasma etching apparatus where it is dissassociated into a reactive plasma. The addition of electronegative gas suppresses arc-like discharges experienced when the plasma encounters surface discontinuities on the substrate such as at an edge of the substrate.

One objective of the present invention is to allow controlled material removal by plasma etching over an entire substrate surface including the edges.

Another objective of the present invention is to provide a material removal tool as a means for optical figuring, for film thickness profiling, and for subsurface damage removal.

Another objective of the present invention is to controllably and predictably plasma etch across a discontinuity in the surface of a substrate so as to obtain a desired removal depth over the entire surface.

Other objects and advantages of the present invention will become apparent to those skilled in the art from the following detailed description read in conjunction with the attached drawings and claims appended hereto.

### DESCRIPTION OF THE DRAWINGS

Fig. 1 illustrates a bowl shaped silicon surface prior to plasma assisted chemical etching of the surface so as to obtain a flat profile over the surface.

Fig. 2 shows the same silicon substrate after plasma assisted chemical etching of the surface and particularly illustrates the formation of a ditch at the edge of the substrate caused by plasma instability at the edge.

### DETAILED DESCRIPTION OF THE PRESENT INVENTION

Superior optically correct surfaces and suitable thickness profiles of solid layers of an entire substrate require processes which can make error corrections in the surface out to the edge of the substrate without adding distortion. Such error corrections can be performed with a plasma assisted chemical etching tool provided that controllable plasma etching can be accomplished at and beyond the edge of the surface where correction is required. In many instances, the error corrections at the edge require that the edge itself receive the plasma etching treatment. However, because the edge of the substrate is a physical discontinuity, it causes a loss of control over the plasma etching process when the plasma etching process is at the edge. Such loss of control can cause associated distortions near the edge of the surface being corrected. The loss of control at the edge often appears in the form of a very intense arc-like discharge which results in localized and unwanted deep removal of material at the edge of the substrate.

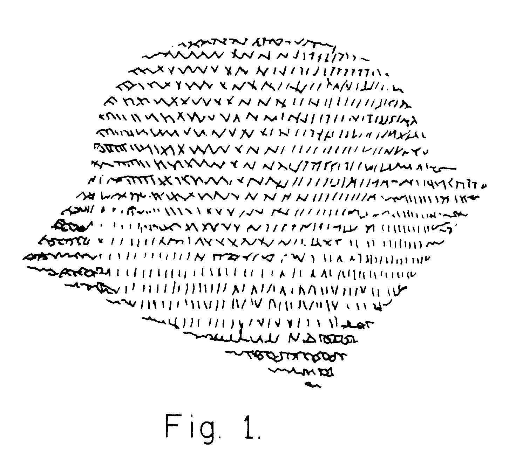

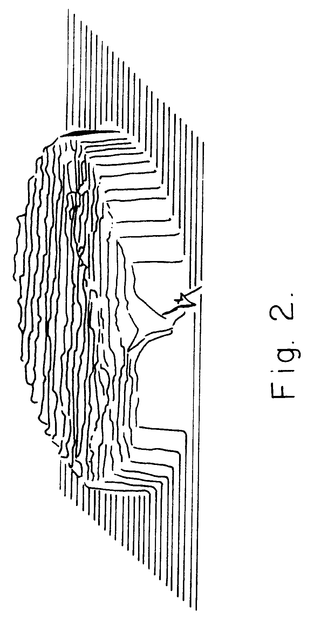

Figure 1 shows a map of a bowl shaped silicon surface prior to surface correction by programmed motion of a plasma assisted chemical etching process, where such process is employed so as to make the surface flat. Figure 2 shows a map of the same substrate surface subsequent to processing by a prior art method. The substrate of the map of Figure 2 undergoes processing with a loose fitting silicon "surround" positioned around it. The function of the "surround" is to add substrate material beyond the actual edge so as to extend the material edge that the plasma experiences well beyond the actual edge of the silicon surface which is the target of etching activity. However, as the figure shows, a ditch at the actual edge of the substrate forms because unstable plasma conditions exist at the interface between the actual edge of the target silicon surface and the "surround". The unstable plasma conditions at the interface cause a loss of control over the material removal mechanism in this region such that intense, arc-like plasma discharges generated remove large volumes of material at the edge.

The present invention provides a means to perform controlled material removal by plasma etching over an entire surface of a substrate including its edges such that intense arc-like discharges are avoided. Thus, the present invention can be used to improve optical figuring, modification of the thickness profile of solid layers on semiconductor wafers such as silicon thinning of a silicon-on-insulator (SOI) wafer, or removal of subsurface damage layers of a substrate over the entire surface. The primary requirement for improved surface shaping processes is the ability to precisely control the depth of the material removal process over the entire substrate surface.

It has been discovered that precise control of the depth of the material removal process over the entire substrate surface can be obtained by the addition of a small amount of an electronegative gas to the gases being fed into a plasma region (the region where gases are converted into a plasma and its corresponding active species). The presence of electronegative gas in this region quenches any discharge instability associated with the edge so that controlled material removal may be performed up to the edge of the substrate. Sulfur hexafluoride is an electronegative gas which is useful to suppress discharge instability. Additions of less than 1 percent by volume can be sufficient to change an unstable plasma at a substrate edge to a completely stable and controllable plasma. Thus, by adding approximately 1 percent by volume of sulfur hexafluoride to a carbon tetrafluoride and argon gas mixture introduced into the plasma region, a very stable and controlled plasma etch can be obtained across the substrate edge. The addition of the highly electronegative gas to suppress plasma instability at edge discontinuities can be applied to surface shaping processes where the plasma is moved with respect to the substrate, and to surface shaping processes where a large static plasma encompasses the substrate and its edges.

Thus, what has been described is a reactive gas composition and method for stable plasma etching over the entire surface of a substrate including the discontinuities thereof which can be used for high precision optical figuring, film thickness profile modification of a substrate, or subsurface damage removal of a substrate.

## Claims

1. A reactive gas mixture for plasma assisted chemical etching to controllably etch the surface of a substrate including the surface discontinuities thereof so as to prevent uncontrolled material removal at said discontinuities by an intense arc-like discharge, said gas mixture comprising a mixture of electronegative gas and reactive gas such that when an radio frequency field is applied to said mixture, said mixture decomposes into species capable of reacting with said substrate surface.

2. The gas mixture of Claim 1, wherein the electronegative gas in the gas mixture fed into said plasma region is the sulfur hexafluoride.

3. The gas mixture of Claim 2, wherein the sulfur hexafluoride contained within said gas mixture is approximately 1 percent by volume to the total gas mixture volume.

4. The gas mixture of Claim 1, wherein the gas mixture comprises a mixture of carbon tetrafluoride, argon, and, approximately 1 percent by volume, sulfur hexafluoride.

5. A reactive gas mixture for plasma assisted chemical etching to controllably etch the surface of a substrate including the surface discontinuities thereof so as to prevent uncontrolled material removal at said discontinuities by an intense arc-like discharge, comprising a mixture of carbon tetrafluoride, argon, and, approximately 1 percent by volume, sulfur hexafluoride.

6. A method to controllably etch the surface of a substrate including the surface discontinuities thereof so as to prevent uncontrolled material removal at said discontinuity caused by an intense arc-like discharge comprising:
moving a plasma assisted chemical etching removal tool with respect to said surface;
feeding a reactive gas mixture containing an electronegative gas into a plasma region of said tool so as to convert said mixture into a plasma in the plasma region.

7. The method of Claim 6, wherein the reactive gas mixture contains sulfur hexafluoride.

8. The method of Claim 7, wherein the sulfur hexafluoride contained within said reactive gas mixture contains is approximately 1 percent by volume to the total reactive gas volume.

9. The method of Claim 6, wherein the reactive gas mixture comprises a gas mixture of carbon tetrafluoride, argon, and, approximately 1 percent by volume, sulfur hexafluoride.

10. The method of Claim 6, wherein the method comprises the additional step of placing material having similar electrical, physical and chemical properties to said substrate around said substrate so as to surround the terminating edges of said substrate prior to etching.
